Europäisches Patentamt

European Patent Office

Office européen des brevets

(11) Publication number: **0 092 041**

**B1**

# EUROPEAN PATENT SPECIFICATION

(45) Date of publication of patent specification: **03.05.89**

(51) Int. Cl.⁴: **H 01 L 21/60**

(21) Application number: **83101747.0**

(22) Date of filing: **23.02.83**

(54) Method for stress relieving in mounted circuit chips.

(30) Priority: **19.04.82 US 369450**

(43) Date of publication of application:
**26.10.83 Bulletin 83/43**

(45) Publication of the grant of the patent:
**03.05.89 Bulletin 89/18**

(84) Designated Contracting States:
**DE FR GB**

(56) References cited:
**US-A-3 486 223**
**US-A-3 993 123**

**IBM TECHNICAL DISCLOSURE BULLETIN, vol. 15, no. 10, March 1973, page 3020, Armonk, New York, US; H.R. FRASER et al.: "Highly wire bondable - low failure exposure top surface metallurgy"**
**IBM TECHNICAL DISCLOSURE BULLETIN, vol. 25, no. 3B, August 1982, page 1464, Armonk, New York, US; S. BHATTACHARYA et al.: "Stress reduction by low temperature intermetallic formation"**

(73) Proprietor: **International Business Machines Corporation**
**Old Orchard Road**
**Armonk, N.Y. 10504 (US)**

(72) Inventor: **Fouts, David Perry**
**Grist Mill Lane**
**Stanfordville New York 12581 (US)**
Inventor: **Jaspal, Jasvier Singh**
**25 Brookland Farm Road**
**Poughkeepsie New York 12601 (US)**
Inventor: **Lloyd, James Robert**
**15 Broad Street**
**Fishkill New York 12524 (US)**
Inventor: **Roush, Walden Bennett**
**Rossway Road**
**Pleasant Valley New York 12569 (US)**
Inventor: **Sullivan, Michael James**
**Box 367**
**Red Hook New York 12571 (US)**

(74) Representative: **Rudack, Günter O., Dipl.-Ing.**
**IBM Corporation Säumerstrasse 4**
**CH-8803 Rüschlikon (CH)**

Courier Press, Leamington Spa, England.

## Description

This invention relates to the art of fabricating semiconductor devices, and more particularly to a method for relieving stresses in circuit chips affixed to a substrate carrier.

One means for connecting very large scale integrated (VLSI) circuit chips with "the outside world" and interconnecting chips with one another to form a complete functional unit is to attach the chips to a multi-layer ceramic (MLC) substrate which has many integral metallic conductors to effect the necessary interconnection between the chips and to provide connection to pins for plugging the thus-fabricated module into other electronic circuitry. The module also includes means for conducting heat from the chips to a heat sink. A typical VLSI circuit module is illustrated in U.S. Patents 3,993,123 and 4,245,273. The method of joining chips to the MLC substrate by means of solder is described in U.S. Patents 3,429,040 and 3,495,133.

The European patent publication EP—A—66694 relates to a method for detecting stresses in the integrated circuit chips, particularly in the assembled state in the module. The problem of chip deformation resulting from the impact loading of the chips by the resiliently mounted pistons used to conduct heat away from the chips is discussed. Handling during manufacturing, shipping and use of the assembled modules produces miniscule impacts which cause plastic deformation of the solder bonds between chips and the MLC substrate, resulting in a strain and derivative stress in the chips.

Stresses in chips not only degrade the operating characteristics of the integrated circuitry which they contain by affecting the properties of the semiconductor materials and their interaction but also may, in the limit, destroy the chip and/or its connection to the MLC substrate. It is, therefore, important to follow the detection technique described in the foregoing European publication with a remedial process to remove the stresses.

To that end this invention provides a post-manufacturing heat treatment wherein the module with the chips bonded thereto is heated to a temperature within the single phase region of the phase diagram for that solder composition used to join the chip to the substrate. The temperature and time relationship is so chosen as to effect grain boundary sliding in the solder under the elastic loading of the deformed chip. The result is that the chip returns to an unstrained/unstressed state and thus restores the module to a functionally satisfactory condition.

The action to relieve stresses may be performed following inspection after the manufacturing operation or may be used to re-work units returned from the field. Details of the inventive method will hereafter be described with reference to the accompanying drawings in which:

Fig. 1 is a representation of a single chip, together with its cooling structure.

Fig. 2 shows the deformation of a chip as a result of impact loading.

Fig. 3 shows the relationship of time and temperature in the relief of chip stress.

Figs. 4A, 4B, 4C show the effect of stress and heat treatment on chip operating parameters.

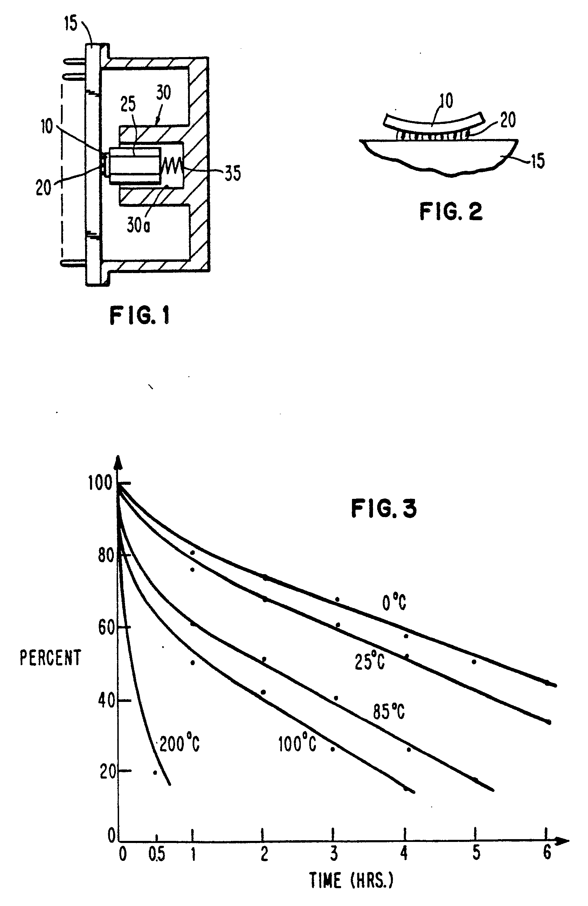

In Fig. 1 one chip, together with its connection to the MLC substrate and the cooling structure is shown for background information. The chip 10 is mechanically and electrically connected to the MLC substrate 15 by means of solder balls 20. A cooling piston 25 is axially slideable in the bore 30a of a so-called "hat" structure 30, and is resiliently urged into intimate contact with the chip 10 by means of spring 35. Both the piston 25 and chip 10 are surface treated so as to provide the maximum surface contact for effective heat transfer. The "hat" structure 30 is interconnected with additional heat conducting and absorbing means, as for example a cooling fluid to maintain the necessary thermal balance so as not to overheat the chip.

An examination of Fig. 1 reveals that the chip 10 will be subjected to dynamic loading by virtue of the resilient mounting of the piston 25, unless, of course the assembly experiences no accelerations during its useful life. The severity of the impact loading, is a function of the magnitude of the acceleration, to which the assembly has been subjected.

The actual chip deformation resulting from a history of repeated impact loads is a complicated function and need not be understood nor sought to be explained. Suffice it to say that chip deformations and the resulting stresses do occur and do adversely affect the functionality of the modules even to the point of catastrophic failure under severe mishandling.

The impact-induced stresses may at least be qualitatively appreciated if one examines the geometry and material properties of the elements of the system. The chip 10 is typically a 4.5 mm square parallele-piped of silicon approximately 0.4 mm thick with its semiconductor structure, interconnecting metallization, and protective quartz overcoat. The MLC substrate, on the other hand, may consist of a sandwich of as many as thirty layers of fired ceramic material and interconnecting conductors. Thus, the substrate 15 is very stiff relative to the chip and will not deform. The chip structure, although relatively brittle, will suffer deformation because of its shape.

Fig. 2 is an enlarged portion of the interface between the chip 10 and the MLC substrate 15, together with the solder balls 20. Obviously this is illustrative only and not to scale, particularly as to the magnitude of the deformation. This deformation is the result of the repeated impact loading imposed on the chip 10 by the piston 25. Each successive impact produces an incremental increase in the deformation and a plastic deformatoin of the solder at room temperature. While there is a certain amount of spring-back upon cessation of the impact loading, the plastic flow in the solder retains a small amount of the deformation. If the history of loading is sufficiently persistent and the impact strong, catastrophic failure may result.

However, before this occurs the functional degradation will usually cause the module to malfunction. It will then be removed from service and can be returnd for rework to remove the deformation and restore it to operative condition.

While it might be thought that the deformation of the chip will produce an elastic force tending to restore the chip to its unstrained condition and thus subject the solder balls to a resultant force causing them to flow, this tendency, while theoretically true, has little practical significance. First, the impact force is greater than the elastic restoring force so that the rate of deformation far exceeds the rate of restoration. Second, the rate of creep (grain boundary sliding, and/or dislocation glide) in the solder is a function of the applied force, composition of the solder and temperature.

The relaxation time decreases with an increase in temperature. Given a constant temperature (e.g. room temperature) the chip will tend to move against the restraint of the solder towards an unstrained condition. However, as the elastic deformation decreases, so too, does the restoring force, and derivatively the force applied to cause plastic flow in the solder. This combination of phenomena contributes to produce an estimated time in excess of twexty-five thousand hours necessary for the chip to be restored to flatness at room temperature. Obviously it would be a rare piece of electronic equipment that would lie dormant for three years so as to be self-healing. Each subsequent interval of rough handling would undo any uncompleted self-healing because of the relativity of the rate of deformation versus that of restoration.

The foregoing is not to be construed that these electronic modules are extremely fragile. There are however, a statistical few whose functionality will be prejudiced by rough handling. By detecting these in their incipient stage of degradation through functional or geometric tests of the device, or through inspection techniques during manufacturing, the failure mechanism can be reversed.

Fig. 3 shows the relative relaxation times for a chip to be relieved of its stress as a function of temperature. The curves represent an initial strain of 2 percent and are plotted as the percentage of stress remaining versus time. The 25°C curve represents the closest approximation to room temperature, while the 85°C represents a temperature in excess of equipment ambient. It will be noted that at 25°C the chip will retain approximately 32% of its initial stress after 6 hours. At 85°C the chip will exhibit about 18% of its initial stress after 5 hours. At 100°C the retained stress is approximately 17% after 4 hours. At 200°C, 20% of the stress remains after 1/2 hour.

The foregoing figures manifest the expected trend of a faster relaxation with an increase in temperature, and would suggest that a further increase in temperature could be advantageously employed in production to remove the deleterious effects of chip stress.

An integrated circuit module is an extremely complex assembly as will be evidenced from a study of one or more of the patents listed above. Therefore, the choice of parameters for relieving chip stress must take into account the effects of the heat treatment upon the total module assembly and all the materials therein. It is not a simple optimization of the process based on the characteristics of the solder alloy alone and reference to the phase diagram of the binary solder alloy used to connect the chips to the ceramic substrate.

While heating the assembly to a higher temperature will indeed raise the rate at which solder creep (grain boundary sliding, and/or dislocation glide) will occur, some of the time advantage of the increased creep rate will be offset by thermal stresses induced in the solder by virtue of the differences in the coefficients of expansion between the silicon chip and the ceramic substrate. The coefficient of expansion of the silicon chip is approximately $3 \times 10^{-6}$ per degree centrigrade, while that of the ceramic substrate is approxixately $6 \times 10^{-6}$ per degree centrigrade in the temperature region of concern. Therefore, the ceramic will expand and contract twice as much for any given temperature change to which the assembly is subjected. Since the actual change in dimensions of the two materials is a linear function of the difference in temperatures (heat treatment temperature minus room temperature) to which the assembly is subjected, it follows that the higher the heat treatment temperature, the greater will be the relative expansion/contraction of the silicon and ceramic. Thus, if the assembly were subjected to an elevated temperature and rapidly cooled this differential expansion (assuming no catastrophic failures) would subject the solder balls connecting the chips to the MLC substrate to a shear stress. This shear stress in the solder will materially shorten the fatigue life of the solder and prejudice the integrity of the solder joint. If the assembly is cooled slowly to permit the solder to creep and thus adjust to the changes in dimensions of the two materials, this cooling time adds to the total cycle time and also shortens the fatigue life of the solder. The cooling time required is a function of the temperature difference. The maximum time temperature product available for relaxing stresses in the chip-to-substrate interconnections is typically limited by degradation mechanisms in the interconnections and other metallurgical structures on a completed substrate chip carrier with attached integrated circuit chips. The continued formation of intermetallics with attendant Kirkendall void formation weakens these structures including, but not limited to, engineering change wires, pin braze connections, flange braze connections, and the interconnections between the integrated circuit chips and the substrate chip carrier. Limitation of the maximum temperature to some temperature below the lowest melting point of the assembly is insufficient, as the metallurgical reactions which weaken the structures proceed in the solid state as well as in the liquid state. Therefore, the thermal stress problem and other considerations discussed commend the use of a lower temperature.

Since the purpose of the heat treatment is to achieve substantial stress relief of the chip and a

3

minimum of thermally induced shear stresses in the solder balls in a minimum overall processing time, a time temperature relationship should be chosen as a compromise between these two phenomena.

It has been found that the optimum results can be achieved by partially disassembling a module by removing the heat transfer structure (pistons 25, springs 35 and hat structure 30, Fig. 1) to expose the chips. After detection of the deflection and a determination of the need for stress relief, the MLC substrate with chips affixed is heated in an oven in an atmosphere of nitrogen until the temperature of the assembly stablizes at 200°C. The assembly is then held at this temperature for 30 minutes and cooled in situ at a rate of 20°C per minute until it achieves a temperature of 50°C when it is removed.

The foregoing parameters are typically achieved by using a box type furnace. To prevent oxidation of the solder pads, a reducing or inert atmosphere is required. The use of a nitrogen atmosphere is sufficient. Temperature has to be monitored. Since it is the chip to substrate interconnection which has to be at 200°C a control module having a precalibrated chip-to-substrate interconnection electrical resistance versus temperature is used to monitor the temperature.

These relationships have been shown by experimentation and test to produce the desired results. Other combinations of time and temperature will produce equally satisfactory results with possible prejudice to the total cycle time. However, a process temperature greater than the lowest temperature of the single phase region for the binary solder alloy utilized should be chosen. The rate of creep is materially greater in the single phase region than it is in the two phase region of the phase diagram. Other percentages of lead-tin solders and other alloys i.e. Pb-In will require suitable modifications to the parameters.

The effect of stress and subsequent heat treatment upon the functional properties of semiconductor devices is illustrated by the change of resistance of an implanted resistor. Specially prepared chips containing a single implanted resistor were subjected to an impact loading by means of a solid piston and elastic system similar to an actual module structure by impacting the assembly at 225 cm per second. The chips were then heat treated for 1/2 hour at 200°C. Resistance measurements made before impacting, after impacting and after heat treatment produced by results in Table I.

TABLE I

| Chip No. | Initial res. | Res. after impact | Res. after heat treatment |
|:---:|:---:|:---:|:---:|
| 1 | 40.25 | 40.20 | 40.28 |
| 2 | 40.64 | 40.60 | 40.67 |
| 3 | 40.33 | 40.27 | 40.37 |

The data in Table I demonstrate that impact decreased the resistance and heat treatment restored the resistance substantially to its prestress value, and in fact increased the resistance leading to a possible conclusion that the prestressed chips may have had some residual stress prior to their being impacted.

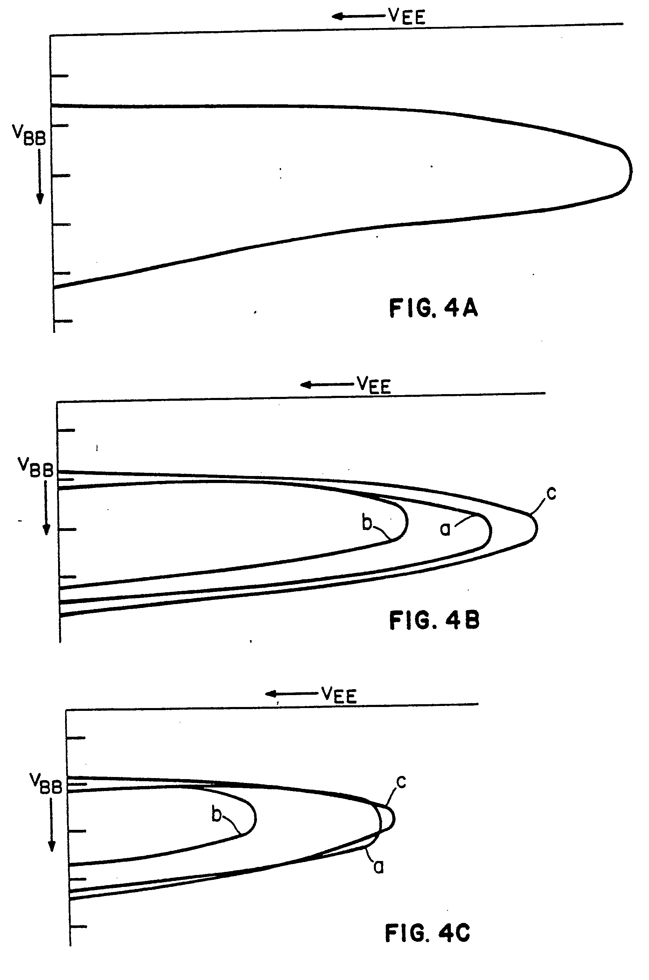

To explore further the effect of stress and heat treatment upon device characteristics, three actual chips were tested. The first chip was reserved as a control to determine the effect, if any, of heat treatment only upon the device characteristics. The second and third chips were subjected to impact loading and then heat treated. Test data were taken on the first chip before and after heat treatment. Data on the second and third chips were taken before loading, after loading, and after heat treatment. The effects are shown qualitatively and roughly quantitatively by the graphs of Figs. 4A—4C. The coordinates of these curves are $V_{EE}$ for the horizontal axis and $V_{BB}$ for the vertical axis with the voltages increasing in the direction of the arrows. The curves themselves represent a constant response time of approximately 14.5 nanoseconds with the paired voltages indicated by the curves. Thus, the greater the area under the curve, the less is the energy required to produce the same response time in the device under test.

In Fig. 4A, which represents the response of the control chip before and after heat treatment, there is only one curve, because the response of the device undergoes so insubstantial a change that the two curves (before and after heat treatment) are indistinguishable from one another. From this it can reasonably be concluded that heat treatment at 200°C and 1/2 hour has no effect upon the device characteristics in an unstressed chip.

The characteristics of the second chip, whose response was measured before impacting, after impacting, and after heat treatment are represented by the three curves a, b and c in Fig. 4B. Curve a represents the prestressed condition, b the stressed condition and c the post heat treatment condition. The b curve relative to the a and c curves manifests a substantial increase in the energy required to maintain a constant response. The substantial congruence of the a and c curves demonstrates the effectiveness of the heat treatment in restoring the device characteristics to the prestress values.

Fig. 4C represents the characteristics of the third chip in the same manner as Fig. 4B does for chip No. 2. It provides further evidence of the adverse effect of impact-induced stress upon the device performance characteristics, and the restoration of those characteristics by the heat treatment.

That the curves in Figs. 4A, 4B and 4C have different shapes is due to differences in the devices and represents the normal variations inherent in a production lot. The curves are not intended to compare one device with another, but to demonstrate the effect of impact-induced stress and the effect of heat treatment.

The foregoing test data demonstrate that semiconductor chips affixed to a ceramic substrate by means of solder balls can be stressed by the impact loading of the cooling pistons and that such stress produces a degradation in the functional parameters of the chips, which parameters can be restored by relieving the stress by the heat treatment hereinabove described.

## Claims

1. Method of relieving stresses in a circuit chip fastened by means of a plurality of discrete solder joints to a dielectric substrate rigid with respect to the chip, said stresses resulting from elastical deformation of the chip and maintenance of such deformation by the plastic flow of the binary solder, said method comprising the steps of:

heating the soldered assembly to a temperature within the single phase region of the solder employed, and maintaining the assembly at the selected temperature for a time sufficient to effect substantially complete grain boundary sliding in said solder to thus restore said chip to a substantially unstressed state.

2. Method according to claim 2, characterized in that the said temperature lies midway between the liquidus temperature and the temperature of the single phase or two phase transition for the solder used to effect the interconnection of the chip and the substrate.

3. Method according to claim 2, characterized in that the temperature is 200°C±10°C.

4. Method according to claim 3, characterized in that the time at which the assembly is maintained at the elevated temperature is in the range from 20 to 30 minutes.

## Patentansprüche

1. Verfahren zur Spannungsentlastung in einem Schaltungschip, der mittels einer Vielzahl von diskreten Lötverbindungen auf einem bezüglich des Chips fixierten dielektrischen Substrat montiert ist, wobei die Spannung durch die elastische Deformation des Chips hervorgerufen und durch den plastischen Fluß des binären Lötzinns aufrechterhalten wird, mit den folgenden Verfahrensschritten:

Erhitzen der gelöteten Anordnung auf eine innerhalb der Einphasen-Zone des verwendeten Lötzinns liegende Temperatur und Halten der Anordnung bei der gewählten Temperatur während einer für die praktisch vollständige Korngrenzenverschiebung in dem genannten Lötzinn ausreichenden Zeit, um dadurch den Chip in einen praktisch spannungslosen Zustand zurückzuführen.

2. Verfahren gemäß Anspruch 1, dadurch gekennzeichnet, daß die genannte Temperatur in der Mitte zwischen der Fließtemperatur und der Übergangstemperatur von dem Einphasen- zum Zweiphasen-System des zur Verbindung von Chip und Substrat verwendeten Lötzinns liegt.

3. Verfharen gemäß Anspruch 2, dadurch gekennzeichnet, daß die Temperatur 200°C±10°C beträgt.

4. Verfahren gemäß Anspruch 2, dadurch gekennzeichnet, daß die Zeit, während welcher die Anordnung bei der erhöhten Temperatur gehalten ist, im Bereich zwischen 20 und 30 Minuten liegt.

## Revendications

1. Procédé de relaxation des constraintes dans une puce de circuit fixée au moyen d'une pluralité de jonctions de soudure distinctes à un substrat diélectrique rigide par rapport à la puce, lesdites constraintes résultant d'une déformation élastique de la puce et du maintien d'une telle déformation par le fluage plastique de la matière de soudure binaire, ledit procédé comprenant les opérations de:

chauffage de l'assemblage soudé à une température située dans la région de phase unique de la matière de soudure employée, et maintien de l'assemblage à la température choisie pendant un temps suffisant pour effectuer un glissement sensiblement complet aux limites des grains dans ladite soudure, afin de ramener ladite puce à un état sensiblement exempt de constrainte.

2. Procédé suivant la revendication 1, caractérisé en ce que ladite température est intermédiaire entre la température de liquidus et la température de transition de la phase unique aux deux phases pour la matière de soudure servant à effectuer l'interconnexion de la puce et du substrat.

3. Procédé suivant la revendication 2, caractérisé en ce que la température est de 200°C±10°C.

4. Procédé suivant la revendication 3, caractérisé en ce que le temps pendant lequel l'assemblage est maintenu à la température élevée est compris entre 20 et 30 minutes.

FIG. 1

FIG. 2

FIG. 3

FIG. 4A

FIG. 4B

FIG. 4C